# FASCICULE DE BREVET EUROPEEN

(11) **EP 1 657 749 B1**
(45) Date de publication et mention de la délivrance du brevet: **31.07.2019**
(21) Numéro de dépôt: 05109904.2
(22) Date de dépôt: 24.10.2005
(51) Int. Cl.: H01L 23/552, H01L 25/065

(54) **Boîtier microélectronique multiplans avec blindage interne**
Mehrlagiges Mikroelektronik-Gehäuse mit interner Abschirmung
Multilevel microelectronic package with internal shielding

(30) Priorité: 29.10.2004 FR 0411607
(43) Date de publication de la demande: 17.05.2006
(73) Titulaire: THALES, 92400 Courbevoie (FR)
(72) Inventeur: Rananjason, Valérie, 78370 Plaisir (FR); Barbier, Thierrry, 78320 Guyancourt (FR); Predon, Eric, 29280 Locmaria Plouzane (FR); Nadal, Ghyslain, 77550 Moissy-Cramayel (FR)
(74) Mandataire: Lucas, Laurent Jacques

(56) Documents cités:
- JP-A- H02 222 598
- JP-A- H08 250 650
- JP-A- 2001 111 232
- US-A- 6 153 928
- US-A1- 2004 023 058

## Description

L'invention concerne le domaine des circuits électroniques à haute densité intégrant sur un même substrat ou carte mère un grand nombre de circuits intégrés ou de circuits microélectronique de type MMIC par exemple. (Monolithic Microwave Integrated Circuits selon la terminologie anglo-saxonne ou encore Circuits Intégrés Monolitiques Microonde). Elle s'applique en particulier aux circuits imprimés hyperfréquences qui sont notamment utilisés dans des domaines tels que les radars, les équipements aéronautiques, les équipements spatiaux, ou encore les télécommunications.

De nos jours, il existe divers procédés de réalisation des fonctions électroniques qui mettent en oeuvre des techniques variées dont l'emploi est fonction des types d'application et en particulier des gammes de fréquences utilisées. Ainsi, dans le domaine des circuits hyperfréquences par exemple, un procédé de réalisation couramment utilisé consiste à assembler les différents composants nécessaires sur un circuit d'interconnexion réalisé à partir d'un substrat présentant de bonnes performances radio-électriques, comme par exemple un substrat en céramique ou en matériau organique. Certains de ces assemblages, les plateaux hyperfréquences, permettent en particulier d'intégrer des composants de type MMIC et de réaliser des circuits hyperfréquences en raccordant entre eux les composants montés sur les substrats. Les raccordements sont par exemple réalisés par des micro-connexions ou des lignes d'adaptation. Les substrats équipés sont ensuite encapsulés sous un couvercle métallique permettant d'isoler des agressions extérieures l'ensemble des éléments montés sur les substrats.

Ces fonctions permettent d'obtenir des performances électriques importantes à des fréquences de fonctionnement élevées. Dans la bande de fréquence 6-18 GHz par exemple, la technologie de montage de circuits sur un substrat en céramique est très largement utilisée.

Cependant la réalisation de tels circuits présente plusieurs inconvénients. En premier lieu c'est un type de réalisation qui met en oeuvre de nombreuses opérations manuelles qui, de ce fait est onéreux. En second lieu, c'est un type de réalisation qui met en oeuvre des opérations de report des différents circuits sur le substrat, ces opérations devant être réalisées en salle blanche dans une atmosphère exempte d'impuretés. En troisième lieu, c'est un type de réalisation qui requiert des moyens de haute technologie comme le micro-câblage, le blindage des puces, l'encapsulage et la fermeture laser du plateau.

D'autre part, le test des différents circuits et modules montés sur ce type de circuits, présente l'inconvénient de devoir être réalisé avant l'encapsulage du plateau et donc dans une salle blanche, équipée des moyens d'essais appropriés. De même, en cas de panne, il est nécessaire, pour procéder à la réparation, de rouvrir le plateau, de repérer les éléments endommagés et de les remplacer. Puis, une fois la réparation effectuée, il convient également d'effectuer un nouveau test et de procéder à la fermeture du plateau. Toutes ces opérations sont également réalisées en salle blanche. Le maintien en condition de fonctionnement de ce type de circuit hyperfréquence est donc peu aisé et par-là même onéreux.

Un moyen connu de s'affranchir des inconvénients précités consiste à réaliser un encapsulage des différents éléments que comporte le plateau hyperfréquence dans des boîtiers individuels. Cet encapsulage individuel s'inspire de la technologie des composants montés en surface utilisée actuellement dans la plupart des cartes imprimées numériques. Il permet de développer des composants unitaires intégrant une seule fonction (un seul élément, un circuit MMIC par exemple) et manipulable en dehors d'une salle blanche. Le développement de tels boîtiers intégrant une unique fonction est notamment divulgué dans la demande de brevet français 0216363 déposée par la demanderesse en 2002.

Ainsi l'assemblage sur le substrat peut être réalisé dans un atelier de câblage traditionnel, le report des différents éléments sur le substrat étant par exemple réalisé au moyen de bille de soudure selon une technique usuelle connue (report par technique Bail Grid Array ou "BGA" selon la terminologie anglo-saxonne). Le précédent plateau hyperfréquence est remplacé par un circuit multicouche sur lequel sont assemblés des boîtiers CMS (Composants Montés en Surface). L'encapsulage est désormais assuré au niveau de chaque boîtier et non plus au niveau du plateau, ce qui facilite les opérations de test et de maintenance. Ainsi, lors d'une opération de maintenance, si un élément ou boîtier est en panne, il suffit de dessouder le boîtier en question et de le remplacer par un élément en état de marche, cette opération ne nécessitant pas d'intervention en salle blanche.

Le travail en salle blanche est ainsi limité à la mise en boîtier des composants MMIC et éventuellement à la réparation d'un composant endommagé. Toutes les autres phases de réalisation du circuit hyperfréquence peuvent être réalisées en atmosphère standard. Par conséquent, les opérations coûteuses de microélectronique en atmosphère contrôlée seront réduites.

Cette méthode de fabrication de circuits électroniques hyperfréquences présente cependant un inconvénient. Cet inconvénient majeur se trouve être l'accroissement de l'encombrement de chacun des éléments ou boîtiers montés sur le circuit porteur multicouche. Il est en effet inévitable qu'un élément encapsulé prenne plus de place que le même élément nu reporté directement sur le substrat. De sorte que cette méthode limite la réalisation des circuits hyperfréquences à haute intégration.

La demande de brevet japonais portant la référence JP 2005 217 348, décrit une structure intermédiaire permettant loger un ou plusieurs composants électroniques et de connecter ces composants à deux circuits imprimés distincts, ladite structure intermédiaire étant configurée pour être disposée entre les deux plans définis par lesdits circuits imprimés et réaliser l'interconnexion électrique. Elle ne constitue cependant pas, en elle-même, un boitier électronique, dans la mesure où elle ne comporte pas d'étage supérieur et inférieur délimitant un tel boitier, mais forme seulement un élément intermédiaire entre deux circuits imprimés.

Pour pallier les inconvénients cités précédemment, il convient donc de définir un dispositif permettant de réaliser des éléments modulaires, donc faciles à manipuler, et présentant un encombrement acceptable permettant de répondre aux besoins d'intégration.

A cet effet, l'invention propose un boîtier électronique multiplans, pouvant héberger dans des plans superposés plusieurs composants et pouvant être monté sur un circuit imprimé ou un substrat comme un composant ou comme un boîtier microélectronique classique.

Selon l'invention, le boîtier comporte au moins un étage supérieur pouvant héberger un premier circuit électronique, un étage inférieur pour héberger un deuxième circuit électronique et une structure intermédiaire en forme de tube supportant l'étage supérieur et posée sur l'étage inférieur.

Selon l'invention, la structure intermédiaire présente dans ses parois des canaux métallisés permettant de réaliser l'interconnexion électrique du plan supérieur avec le plan inférieur et les points de connexion externe de la structure. Les circuits microélectroniques des étages supérieur et inférieur comporte sur leurs périphéries des points de connexion agencés de façon à être situés en regard des surfaces métallisées lorsque le boîtier est assemblé.

Selon l'invention l'assemblage du boîtier est réalisé par des moyens permettant de réaliser de façon automatique des connexions entre le circuit électronique hébergé dans le plan supérieur, les canaux métallisés de la structure intermédiaire et les points de connexion externe situés sur le plan inférieur.

Ces moyens permettent également d'assurer le blindage électrique et l'étanchéité du boîtier.

Selon une autre caractéristique, le plan supérieur, le plan inférieur et la structure intermédiaire sont réalisé dans des matériaux organiques présentant les caractéristiques électriques appropriées, selon un procédé connu de fabrication de circuits imprimés multicouches

Selon une autre caractéristique, la structure intermédiaire présente un plan intermédiaire permettant d'isoler chacun des plans inférieur et supérieur des rayonnements électromagnétiques provenant du plan en vis à vis.

Selon une autre caractéristique, le plan supérieur peut être coiffé d'une plaque métallique formant un drain thermique pour un composant de puissance placé dans ce plan.

D'autres caractéristiques et avantages apparaîtront au fil de la description qui suit, description réalisée en regard des figures annexées qui représentent:
- la figure 1, une vue générale en coupe d'une version simplifiée du dispositif selon l'invention, non couverte par les revendications, permettant de mettre en évidence certaine caractéristiques techniques de ce dernier,
- la figure 2, une vue générale en coupe d'un mode de réalisation du dispositif selon l'invention,
- la figure 3, une vue schématique de la face inférieure d'un exemple de circuit formant un étage supérieur,
- la figure 4, une vue schématique de dessus de la structure intermédiaire correspondant à l'exemple d'étage supérieur de la figure 2,
- la figure 5, une vue schématique de la face supérieure d'un exemple de circuit formant un étage inférieur,
- les figures 6 et 7, des illustrations des opérations de fabrication sous forme de panoplies, des éléments composant le boîtier selon l'invention.

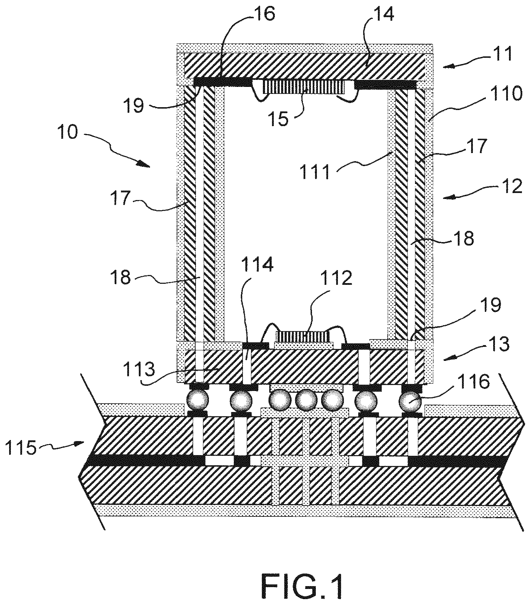

La figure 1 présente une vue en coupe transversale verticale d'une version simplifiée du dispositif selon l'invention, ne faisant pas partie en elle-même de l'invention telle que revendiquée. Le dispositif selon l'invention est ici représenté, pour faciliter la compréhension, dans une version simplifiée ne comportant que deux plans. Cette représentation ne représente bien entendu pas une limitation structurelle, le dispositif pouvant adopter une structure plus complexe comportant par exemple trois étages et intégrant ainsi trois niveaux de circuits intégrés.

Comme on peut le constater sur la figure 1, le dispositif selon l'invention 10 comporte trois parties distinctes: un étage supérieur 11, une structure intermédiaire 12 et un étage inférieur 13.

L'étage supérieur 11 comporte principalement un circuit imprimé 14 sur lequel est par exemple implanté un circuit intégré 15 raccordé aux pistes 16 imprimées sur le circuit 14. Dans l'exemple de la figure 1, les faces supérieure et inférieure ainsi que les bords du circuit 14 sont métallisés.

La structure intermédiaire 12 se présente comme un tube de section rectangulaire dont la longueur et la largeur sont sensiblement égales respectivement à la longueur et à la largeur de l'étage supérieur 11. Comme l'illustre l'exemple de la figure 1, les parois 17 de la structure intermédiaire sont traversées des canaux métallisés 18 terminés à chaque extrémité par une métallisation. Ces canaux métallisés ont pour rôle de véhiculer des signaux électriques de l'étage supérieur vers l'étage inférieur. Ils sont par ailleurs disposés dans la structure de façon à ce que leurs extrémités se trouvent en regard de points de connexion 19 des circuits imprimés constituant l'étage supérieur et l'étage inférieur. La structure intermédiaire remplit donc ainsi un double rôle. Elle maintient l'étage supérieur au-dessus de l'étage inférieur à une distance déterminée. Elle réalise également l'interconnexion inter-plans verticale entre les deux étages 11 et 13 et permet de ramener tous les points de connexion externe du dispositif dans le plan représenté par la face inférieure de l'étage inférieur 13.

Les parois externes 110 et internes 111 de la structure intermédiaire sont généralement métallisées de façon à pouvoir réaliser un blindage empêchant la pénétration de perturbations électromagnétiques à l'intérieur de la structure, et le rayonnement d'ondes électromagnétiques depuis l'intérieur vers l'extérieur.

L'étage inférieur 13 comporte également un circuit électronique monté sur un circuit imprimé 113. Cet étage peut par exemple comporter, comme dans l'exemple de la figure, deux zones séparées: une zone centrale destinée à l'implantation du composant 112 et une zone périphérique sur laquelle repose la structure intermédiaire 12.

La partie centrale présente dans ce cas des trous métallisés 114 permettant de réaliser par la face inférieure de l'étage, la connexion externe du composant 112 sur le circuit substrat 115. La partie périphérique quant à elle présente des trous métallisés positionnés en regard des canaux métallisés 18 de la structure intermédiaire, permettant de réaliser par la face inférieure de l'étage inférieur, la connexion externe du composant 15 de l'étage supérieur sur le circuit substrat 115.

Le circuit imprimé constituant l'étage inférieur 13 présente également des faces et des bords métallisés.

L'assemblage des divers éléments du dispositif selon l'invention peut être réalisé par tout moyen connu d'assemblage de circuits imprimés, comme par exemple l'application dans les zones de contact d'une pâte à braser et la cuisson de l'assemblage à une température permettant la fusion de la pâte, l'utilisation de colles anisotropiques ou d'un collage sélectif ainsi que tout autre assemblage, par exemple soudure intermétallique, ou connexion par pression.

On obtient ainsi un boîtier monobloc étanche pouvant être manipulé comme un simple composant électronique et monté sur un circuit imprimé 115 selon des méthodes de câblage connues, telles que le câblage au moyen de billes de soudure 116 par exemple.

Le boîtier ainsi constitué présente l'avantage important de ne nécessiter aucune opération de câblage filaire pour réaliser l'interconnexion inter-plans entre l'étage supérieur, l'étage inférieur et le plan de connexion au circuit imprimé 115 principal.

Le boîtier ainsi construit présente également l'avantage, de par la métallisation de tous ses éléments 11, 12 et 13, d'être pourvu d'un blindage équivalent à celui obtenu pour un composant encapsulé connu de l'art antérieur. Il peut donc naturellement abriter des composants sensibles aux perturbations électromagnétiques.

Du point de vue de la fabrication, les différents éléments 11, 12 et 13 du dispositif selon l'invention, sont avantageusement réalisés selon une technique de réalisation de circuits imprimés multicouches. Le matériau utilisé est ici un matériau plastique organique tramé ayant les propriétés diélectriques adaptées à la fréquence de travail des composants notamment dans le cas où le boîtier réalisé abrite des composants hyperfréquences. Pour les composants opérant dans une gamme de fréquence comprise par exemple entre 2 et 20GHz, le boîtier peut être réalisé dans un matériau ayant un εᵣ compris entre 2.2 et 13 et un facteur de dissipation diélectrique tgδ variant depuis 0,0009 à 0,003.

On rappelle ici que le facteur de dissipation diélectrique, t_{g}, traduit les pertes dites diélectriques que subit un signal hyperfréquence au passage dans un matériau diélectrique. Plus ce facteur est faible, moins le signal est atténué. Le terme t_{g}, exprime en dB/m, l'atténuation due au matériau diélectrique que subit le signal hyperfréquence. Il tient compte également des pertes ohmiques du conducteur métallique qui viennent s'ajouter aux pertes diélectriques.

Parmi la gamme de matériaux disponible sur le marché et présentant des caractéristiques hyperfréquences compatibles en large bande, on peut par exemple citer, de façon non limitative, les références RO 4003 et RO 4350 fabriqués par la société ROGERS et la référence 25N fabriqué par la société ARLON.

L'utilisation d'un matériau organique présente l'avantage particulier de permettre de réaliser de manière simple la structure intermédiaire. En effet, cette structure doit pouvoir être suffisamment haute pour permettre de loger deux circuits à l'intérieur de la cavité formée et un bon découplage électromagnétique de l'étage supérieur et de l'étage inférieur. L'utilisation de matériaux du type de ceux cités précédemment permet par exemple de réaliser des structures intermédiaires non limitées en hauteur et des parois d'une épaisseur pouvant atteindre environ 1 mm.

Avantageusement, l'utilisation de matériaux organiques permet également de réaliser, dans une structure intermédiaire relativement haute, des canaux métallisés d'interconnexion tels que ceux décrits précédemment, opération qui n'est pas aisément réalisable, voire impossible à partir d'autres matériaux utilisés pour des circuits hyperfréquences comme par exemple des substrats céramiques, en couche mince ou en couche épaisse.

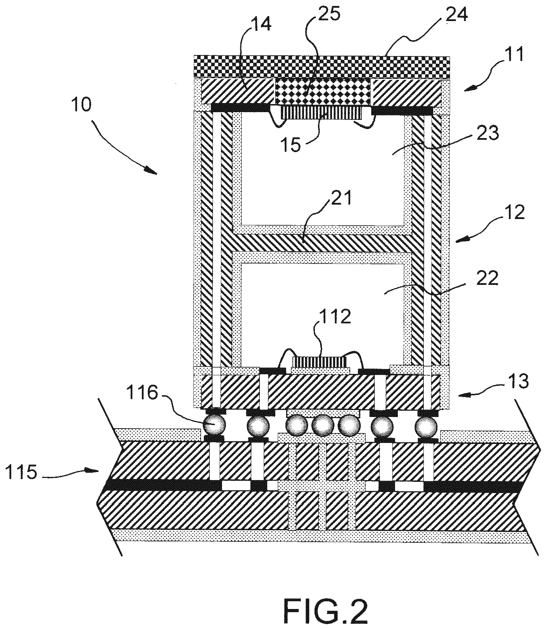

La figure 2 présente une vue en coupe transversale verticale du dispositif selon l'invention, dans un mode de réalisation présenté à titre d'exemple.

Ce mode de réalisation est adapté à la réalisation de boîtiers hyperfréquences, comportant par exemple un circuit récepteur implanté sur l'étage inférieur et un circuit émetteur implanté sur l'étage supérieur.

Ce mode de réalisation, qui constitue le mode préféré, diffère du dispositif simplifié décrit à la figure 1 en ce que la structure intermédiaire 12 présente une cloison intermédiaire 21 permettant de délimiter deux cavités 22 et 23 dont les parois sont métallisées et qui réalisent un isolement électromagnétique complet du circuit récepteur 112 par rapport au circuit émetteur 15. Cet isolement est équivalent à celui qui serait obtenu par des encapsulages séparés des deux circuits. Il est ainsi possible de monter dans un même boîtier selon l'invention, un circuit fonctionnant à fort niveau et un circuit de grande sensibilité.

Ce mode de réalisation présente également un étage supérieur différent de celui présenté à la figure 1. En effet ce second type de boîtier étant destiné à recevoir un circuit émetteur implanté sur l'étage supérieur il est nécessaire de disposer d'un moyen de réaliser la dissipation thermique du circuit. A cet effet, l'étage supérieur est coiffé d'une semelle métallique 24 formant un drain thermique. Cette semelle métallique, en cuivre par exemple, peut-être mise en contact si nécessaire avec le circuit émetteur au moyen d'une couche d'adaptation 25 constitué d'un alliage métallique ayant un coefficient de dilatation semblable à celui de l'élément 15 de la figure 1, de type cuivre-molybdène par exemple. La semelle est par ailleurs assemblée à la face supérieure de l'étage supérieur au moyen de pâte à braser ou par tout autre moyen connu.

Ainsi comme l'illustre la figure 2 il est possible de réaliser un boîtier multiplans selon l'invention capable d'héberger un ensemble émission - réception hyperfréquence assurant un découplage suffisant entre l'émission et la réception. Ce type de boîtier peut être avantageusement utilisé dans des domaines techniques où l'encombrement d'un composant est un facteur essentiel, comme par exemple la réalisation d'antennes actives comportant des modules d'émission - réception (T/R modules) dont l'espacement est fixé par les paramètres de fonctionnement de l'antenne. Plus généralement la structure illustrée par la figure 2. permet de faire cohabiter dans un même boîtier multiplans selon l'invention, des circuits à fort rayonnement électromagnétique et des circuits présentant une grande sensibilité aux rayonnements. Dans ce contexte la hauteur des cavités 22 et 23 formées par la structure intermédiaire 12 prend en compte les contraintes d'isolement.

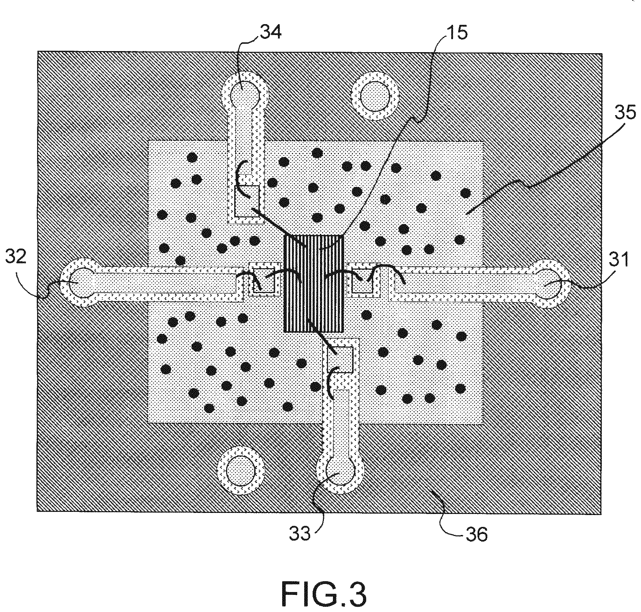

Les figures 3, 4 et 5 représentent des illustrations schématiques des différents éléments du boîtier selon l'invention.

La figure 3 représente une illustration schématique du circuit imprimé composant l'étage supérieur en vue de dessous. Le circuit imprimé schématisé ici à titre d'exemple, comporte un composant électronique 15 et des circuits d'entrée et de sortie du signal utile, comportant des zones de connexion 31 et 32 localisées. Le circuit de la figure 3 comporte également deux circuits d'alimentation pourvus également de zones de connexion 33 et 34. Les zones de connexion sont situées en périphérie du circuit imprimé composant l'étage supérieur de façon à pouvoir être connectées aux canaux correspondants de la structure intermédiaire lors de l'assemblage du boîtier selon l'invention. Le circuit imprimé constituant l'étage supérieur est ainsi divisé en deux zones, une zone centrale 35 regroupant l'ensemble des fonctions réalisées sur le circuit, qui constitue la partie fonctionnelle du circuit, et une zone périphérique 36 permettant l'interconnexion du circuit avec l'étage inférieur à travers la structure intermédiaire.

Comme l'illustre la figure 3, la zone périphérique est entièrement métallisée à l'exception de zones d'épargne situées autour des zones de connexion 31 à 34. Cette métallisation permet l'assemblage de l'étage supérieur à la structure.

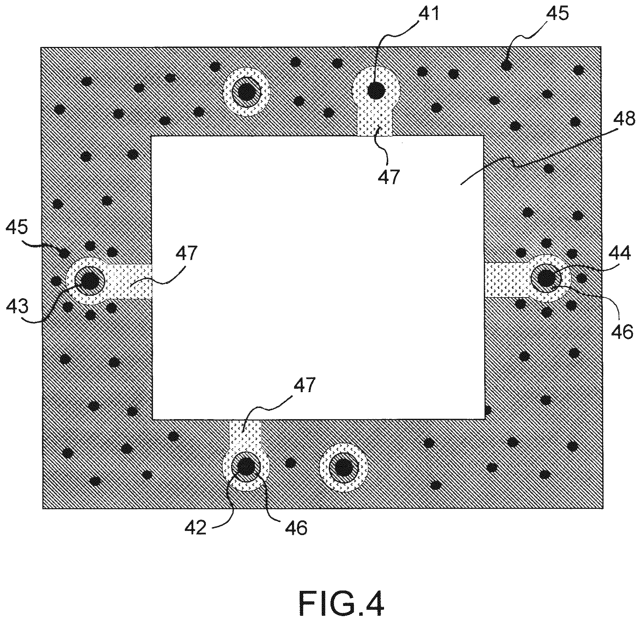

La figure 4 est une illustration schématique, en vue de dessus par exemple, de la structure intermédiaire. Comme l'illustre la figure, cette structure se présente comme un tube de section rectangulaire évidé en son centre et dont les parois présentent des canaux métallisés représentés schématiquement sur la figure 4. Ces canaux sont positionnés de façon à se trouver, au moment de l'assemblage du boîtier, en regard des points de connexion correspondants situés sur les circuits imprimés composant les plans supérieur et inférieur. Ainsi par exemple, après assemblage d'un boîtier correspondant aux figures 3 à 5, le canal 43 de la figure 4 serait mis en contact avec la surface de connexion 31 du circuit imprimé de la figure 3, ce contact pouvant être réalisé, comme il a été dit précédemment au moyen de pâte à braser par exemple.

Parmi ces canaux, certains, comme les canaux 41 et 42 de la figure 1, véhiculent des signaux d'alimentation basse fréquence et ont pour simple rôle celui de conducteur électrique. D'autre en revanche comme les canaux 43 et 44, servent de guides aux signaux hyperfréquences d'entrée et de sortie et se comportent comme des transitions hyperfréquences coaxiales classiques. A cet effet, chacun de ces canaux est entouré de canaux de traversée métallisés 45, reliés à la masse de la structure.

Les canaux métallisés présentent à leurs extrémités une surface métallisée 46 permettant de réaliser leur interconnexion avec les zones de connexion des circuits formant les plans supérieur et inférieur.

Les parois de la structure intermédiaire sont en outre traversées d'un certain nombre de canaux de traversée 45 dont le rôle est notamment d'assurer la continuité de masse entre le plan supérieur et le plan inférieur.

Comme pour les circuits imprimés formant les plans supérieur et inférieur, la face supérieure et la face inférieure de la structure intermédiaire sont entièrement métallisées à l'exception des zones d'épargne 47.

Selon le mode de réalisation la partie centrale 48 de la structure peut être totalement évidée. Elle peut également, comme dans le mode de réalisation illustré par la figure 2, être partiellement évidée à chacune de ses extrémités et laisser subsister une cloison en son milieu.

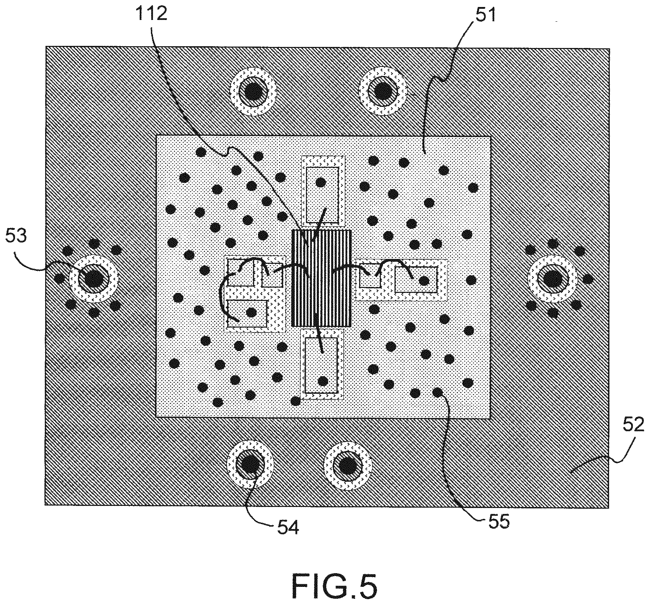

La figure 5 représente de manière schématique une vue de la face supérieure d'un circuit imprimé composant l'étage inférieur d'un boîtier selon l'invention. Comme on peut le constater sur la figure 5, ce circuit imprimé peut comporter deux zones séparées, une zone centrale 51 et une zone périphérique 52. La zone centrale peut par exemple comporter un circuit électronique hyperfréquence indépendant comportant ses propres traversées métallisées 55, tandis que la zone périphérique, recouverte par les parois de la structure intermédiaire assure la transition vers le plan inférieur de l'étage inférieur aux signaux provenant de l'étage supérieur ou à destination de celui-ci. A cet effet elle est traversée de trous métallisés mettant en communication la face supérieure et la face inférieure du circuit imprimé constituant l'étage inférieur. Ainsi dans l'exemple des figures 3 à 5, le signal issu du circuit 15 traversant chemine du plan supérieur 11 à la zone de connexion du boîtier sur le circuit imprimé principal 115, via la surface de connexion 31, le canal métallisé 43 de la structure intermédiaire 12 et le trou métallisé traversant le plan inférieur. De même un signal d'alimentation basse fréquence pourrait être fourni au circuit 15 via le trou métallisé 54 du plan inférieur 13, le canal métallisé 42 de la structure intermédiaire 12 et la surface de connexion 33 du plan supérieur 11.

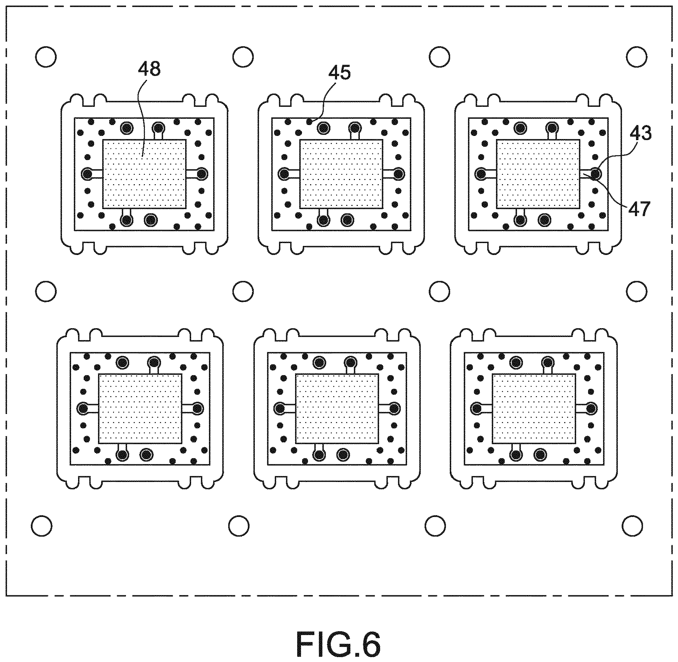

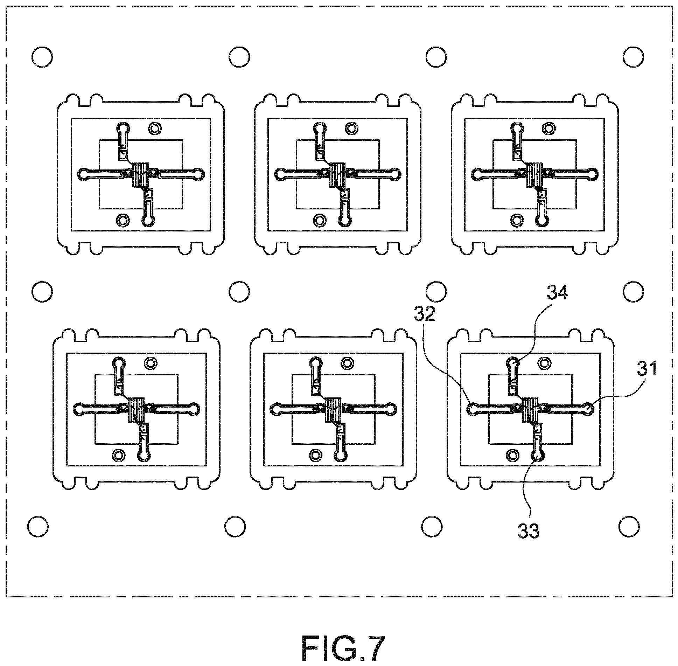

Du point de vue de la fabrication, le boîtier selon l'invention présente l'avantage important de pouvoir être réalisé en série sous forme de panoplies prêtes à être assemblées. A titre d'exemple, les figures 6 et 7 illustrent de manière schématique la réalisation sous forme de panoplie d'une structure intermédiaire et d'un circuit constituant un étage supérieur du boîtier selon l'invention. Chaque panoplie se présente comme une plaque de matériau organique du type de ceux cités précédemment, sur laquelle sont détourées des zones correspondant aux circuits imprimés à réaliser. L'ensemble des opérations de gravure des pistes imprimées, de perçage et de métallisation des trous de traversée, d'implantation et de câblage des composants, de métallisation des surfaces et des bords des circuits imprimés, est de la sorte réalisé en série sur toute la panoplie. Une fois achevés, les circuits imprimés sont séparés et assemblés avec les autres circuits imprimés composant un type de boîtier donné.

Comme on peut le constater, le boîtier multiplans tel que décrit dans la présente demande présente de grands avantages. Il permet en particulier de réaliser des structures modulaires de type module émission-réception dans un encombrement restreint tout en assurant un découplage satisfaisant des composants logés sur les étages supérieur et inférieur d'un même boîtier. Il est d'autre part d'un assemblage facile, la structure intermédiaire et les étages étant assemblés par exemple par brasage. Il permet en outre de limiter le nombre d'opérations devant être réalisées en atmosphère contrôlée, dans des locaux de type "salle blanche", le boîtier assemblé pouvant être manipulé et monté sur un circuit imprimé comme n'importe quel composant. Sa structure intermédiaire, avec ses canaux métallisés permet en outre de réaliser une interconnexion automatique qui évite la connexion filaire de l'étage supérieur sur l'étage inférieur et permet d'assembler le boîtier sur un circuit imprimé comme n'importe quel composant monté en surface. Ce boîtier à usage général peut accueillir tout type de composant comme par exemple des circuits MMIC, fonctionnant à des fréquences pouvant atteindre quelques dizaines de Gigahertz.

## Revendications

1. Boîtier microélectronique multiplans (10), du type comportant
- un étage supérieur (11) comportant sur sa face inférieure au moins un circuit imprimé microélectronique (15),
- un étage inférieur (13) comportant sur sa face supérieure au moins un circuit imprimé microélectronique (112),
- une structure intermédiaire (12) tubulaire séparant l'étage supérieur de l'étage inférieur dont la section possède des dimensions adaptées aux dimensions des plans inférieur et supérieur,
la structure intermédiaire étant une structure unitaire, réalisée en une seule pièce dans le même matériau organique que les circuits imprimés des étages supérieur et inférieur, indépendante des étages inférieur et supérieur, posée sur l'étage inférieur (13) et portant l'étage supérieur (11), la structure intermédiaire étant réalisée de façon à former deux cavités (22, 23) séparées par une cloison horizontale (21) permettant d'isoler de manière réciproque un étage des radiations électromagnétiques produites par l'autre étage;
les parois desdites cavités étant métallisées; ledit boitier étant **caractérisé en ce que** la face supérieure et la face inférieure de la structure intermédiaire (12) ainsi que les zones périphériques des circuits imprimés des étage supérieur et inférieur en contact avec ces faces sont entièrement métallisées, à l'exception de zones d'épargne situées autour de zones de connexion, ces métallisations permettant l'assemblage de ces trois éléments de façon à former un boîtier étanche.

2. Boîtier microélectronique selon la revendication 1, **caractérisé en ce que** la structure intermédiaire (12) comporte dans ses parois des canaux métallisés (41-44), terminés par des surfaces métallisées (46), le premier (11) et le deuxième (12) circuit imprimé comportant sur leurs périphéries des points de connexion (31-34) agencés de façon à être situés en regard des surfaces métallisées (46) lorsque le boîtier est assemblé, les canaux métallisés (41-44) venant s'interconnecter avec les points de connexion (31-34) des étages supérieur (11) et inférieur (13) de façon à pouvoir réaliser de manière automatique, lors de l'assemblage du boîtier, l'interconnexion entre lesdits étages supérieur et inférieur.

3. Boîtier microélectronique selon l'une des revendications 1 ou 2, **caractérisé en ce que** les étages supérieur (11) et inférieur (13) sont de forme rectangulaire et la structure intermédiaire (12) de section rectangulaire.

4. Boîtier microélectronique selon l'une quelconque des revendications précédentes, **caractérisé en ce que** les parois externes (110) de la structure intermédiaire, la face supérieure de l'étage supérieur (11) ainsi que la face inférieure de i'étage inférieur (13) sont métallisées, de façon à réaliser un blindage électromagnétique de l'espace intérieur du boîtier.

5. Boîtier microélectronique selon l'une quelconque des revendications précédentes, **caractérisé en ce que** le circuits microélectronique de l'étage inférieur comporte des traversées métallisées (53) permettant de réaliser l'ensemble de l'interconnexion du boîtier sur un circuit imprimé par la face inférieur de l'étage inférieur, au moyen de billes de soudure (116).

6. Boîtier électronique selon l'une quelconque des revendications précédentes, **caractérisé en ce que** le circuit microélectronique (14) de l'étage supérieur (11) comportant un composant électronique de puissance (15), l'étage supérieur est équipé sur sa face supérieure d'une plaque métallique (24) permettant de dissiper la chaleur produite par ledit circuit.

## Patentansprüche

1. Mehrebenen-Mikroelektronikgehäuse (10) des Typs, der umfasst:
- eine obere Stufe (11), die an ihrer Unterseite mindestens eine gedruckte Mikroelektronikschaltung (15) umfasst,
- eine untere Stufe (13), die an ihrer Oberseite mindestens eine gedruckte Mikroelektronikschaltung (112) umfasst,
- eine rohrförmige Zwischenstruktur (12), welche die obere Stufe von der unteren Stufe trennt und deren Querschnitt Abmessungen besitzt, die an die Abmessungen der oberen und unteren Ebenen angepasst sind,
wobei die Zwischenstruktur eine einteilige Struktur ist, die aus einem einzigen Stück aus demselben organischen Material wie die gedruckten Schaltungen der oberen und unteren Stufen ausgeführt ist, von den unteren und oberen Stufen unabhängig ist, auf die untere Stufe (13) gesetzt ist und die obere Stufe (11) trägt, wobei die Zwischenstruktur so ausgeführt ist, dass sie zwei Hohlräume (22, 23) bildet, die durch eine waagerechte Trennwand (21) getrennt sind, die eine Stufe der von der anderen Stufe erzeugten elektromagnetischen Strahlung gegenseitig isoliert; wobei die Wände der Hohlräume metallisiert sind; wobei das Gehäuse **dadurch gekennzeichnet ist, dass** die Oberseite und die Unterseite der Zwischenstruktur (12) sowie die Umfangsbereiche der gedruckten Schaltungen der oberen und unteren Stufen, die in Kontakt mit diesen Seiten sind, vollständig metallisiert sind, mit Ausnahme der ausgesparten Bereiche um die Anschlussbereiche herum, wobei diese Metallisierungen das Montieren dieser drei Elemente so ermöglichen, dass ein dichtes Gehäuse gebildet wird.

2. Mikroelektronikgehäuse nach Anspruch 1, **dadurch gekennzeichnet, dass** die Zwischenstruktur (12) in ihren Wänden metallisierte Kanäle (41-44) umfasst, die in metallisierten Flächen (46) enden, wobei die erste (11) und die zweite (12) gedruckte Schaltung an ihren Umfängen Anschlussstellen (31-34) umfassen, die so angeordnet sind, dass sie, wenn das Gehäuse montiert ist, gegenüber den metallisierten Flächen (46) liegen, wobei sich die metallisierten Kanäle (41-44) mit den Anschlussstellen (31-34) der oberen (11) und unteren (13) Stufen so verbinden, dass sie beim Montieren des Gehäuses automatisch die Verbindung zwischen den oberen und unteren Stufen ausführen.

3. Mikroelektronikgehäuse nach einem der Ansprüche 1 oder 2, **dadurch gekennzeichnet, dass** die oberen (11) und unteren (13) Stufen rechteckig sind und die Zwischenstruktur (12) einen rechteckigen Querschnitt hat.

4. Mikroelektronikgehäuse nach einem der vorhergehenden Ansprüche, **dadurch gekennzeichnet, dass** die Außenwände (110) der Zwischenstruktur, die Oberseite der oberen Stufe (11) sowie die Unterseite der unteren Stufe (13) metallisiert sind, so dass eine elektromagnetische Abschirmung des Innenraums des Gehäuses ausgeführt wird.

5. Mikroelektronikgehäuse nach einem der vorhergehenden Ansprüche, **dadurch gekennzeichnet, dass** die Mikroelektronikschaltung der unteren Stufe metallisierte Durchkontaktierungen (53) umfasst, die es ermöglichen, die gesamte Verbindung des Gehäuses auf einer gedruckten Schaltung über die Unterseite der unteren Stufe mittels Lotkugeln (116) auszuführen.

6. Elektronikgehäuse nach einem der vorhergehenden Ansprüche, **dadurch gekennzeichnet, dass**, wenn die Mikroelektronikschaltung (14) der oberen Stufe (11) ein elektronisches Leitungsbauelement (15) umfasst, die obere Stufe an ihrer Oberseite mit einer Metallplatte (24) ausgestattet ist, die es ermöglicht, die von der Schaltung erzeugte Wärme abzuführen.

## Claims

1. Multilevel microelectronic package (10), of the type comprising
- an upper level (11) comprising on its lower face at least one microelectronic printed circuit board (15),
- a lower level (13) comprising on its upper face at least one microelectronic printed circuit board (112), and
- a tubular intermediate structure (12) separating the upper level from the lower level, the cross section of which possesses dimensions that are adapted to the dimensions of the lower and upper levels,
the intermediate structure being a unitary structure that is produced in a single piece from the same organic material as the printed circuit boards of the upper and lower levels, that is independent of the lower and upper levels, that is placed on the lower level (13) and that bears the upper level (11), the intermediate structure being produced so as to form two cavities (22, 23) that are separated by a horizontal partition (21) that allows reciprocally one level to be isolated from the electromagnetic radiation produced by the other level; the walls of said cavities being metallized; said package being **characterized in that** the upper face and the lower face of the intermediate structure (12) and the peripheral zones of the printed circuit boards of the upper and lower levels making contact with these faces are entirely metallized, with the exception of spared zones located about connection zones, these metallizations allowing these three elements to be assembled so as to form a seal-tight package.

2. Microelectronic package according to Claim 1, **characterized in that** the intermediate structure (12) comprises in its walls metallized channels (41-44) that are terminated by metallized surfaces (46), the first printed circuit board (11) and the second printed circuit board (12) comprising on their peripheries connection points (31-34) that are arranged so as to be located facing the metallized surfaces (46) when the package is assembled, the metallized channels (41-44) interconnecting with connection points (31-34) of the upper level (11) and of the lower level (13) so as to be able to automatically produce, during the assembly of the package, the interconnection of said upper and lower levels.

3. Microelectronic package according to either of Claims 1 and 2, **characterized in that** the upper level (11) and lower level (13) are of rectangular shape and the intermediate structure (12) is of rectangular cross section.

4. Microelectronic package according to any one of the preceding claims, **characterized in that** the external walls (110) of the intermediate structure, the upper face of the upper level (11) and the lower face of the lower level (13) are metallized, so as to electromagnetically shield the interior space of the package.

5. Microelectronic package according to any one of the preceding claims, **characterized in that** the microelectronic circuit board of the lower level comprises metallized feedthroughs (53) allowing complete interconnection of the package and a printed circuit board to be achieved, via the lower face of the lower level, by means of solder bumps (116).

6. Electronic package according to any one of the preceding claims, **characterized in that**, the microelectronic circuit board (14) of the upper level (11) comprising a power electronic component (15), the upper level is equipped, on its upper face, with a metal plate (24) allowing the heat produced by said circuit board to be dissipated.
